# EUROPEAN PATENT APPLICATION

(11) **EP 1 035 438 A2**
(43) Date of publication of application: **13.09.2000**
(21) Application number: 00301882.7
(22) Date of filing: 08.03.2000
(51) Int. Cl.: G03F 7/023, C08L 61/00

(54) **Phenolic resins and photoresist compositions comprising same**

(30) Priority: 12.03.1999 US 267054
(71) Applicant: Shipley Company LLC, Marlborough, MA 01752 (US)
(72) Inventor: Zampini, Anthony, Westborough, Massachusetts 01581 (US); Xu, Cheng-Bai, Southborough, Massachusetts 01772 (US); Sandford, Harold F., Groton, Massachusetts 01450 (US)
(74) Representative: Buckley, Guy Julian

(57) **Abstract**

The invention provides these novel resins and photoresist compositions that comprise a photoactive component and one or more resins of the invention. In one aspect, resins of the invention can be characterized by use of a prepolymer reagent that is a reaction product of a methylol phenol compound. The methylol phenol compound is suitably reacted at above room temperature and/or in the presence of acid.

## Description

### BACKGROUND OF THE INVENTION

### 1. Field of the Invention

The present invention relates to new phenolic resins, methods for synthesizing such resins and photoresist compositions that contain such resins.

### 2. Background

Photoresists are photosensitive films used for transfer of images to a substrate. A coating layer of a photoresist is formed on a substrate and the photoresist layer is then exposed to patterned activating radiation. Exposure to activating radiation provides a photoinduced chemical transformation of the photoresist coating to thereby transfer the desired pattern to the photoresist coated substrate. Following exposure, the photoresist is developed to provide a relief image that permits selective processing of a substrate. The use of photoresists is generally described, for example, in Deforest, *Photoresist Materials and Processes*, McGraw Hill Book Company, New York, ch. 2, 1975 and by Moreau, *Semiconductor Lithography, Principles, Practices and Materials*, Plenum Press, New York.

Various attempts have been made to alter the make-up of photoresist compositions to improve performance of functional properties. Among other things, a variety of resins have been reported for use in photoresist compositions. See, for example, U.S. Patents 5,235,022 and 5,234,795. Particularly useful resins are disclosed in U.S. Patents 5,130,410; 5,238,776; 5,529,880; and 5,589,553, all having an inventor of Zampini and assigned to the Shipley Company.

Known photoresists can provide features having resolution and size sufficient for many existing commercial applications. However, for many other applications, the need exists for new photoresists that can provide enhanced performance.

Among other things, some current resists do not remain in solution over extended storage and instead will precipitate particles. Storage stability is typically of high importance for a photoresist. Generally, after photoresist manufacture, a resist is stored for several months or more prior to use by a device manufacturer. Particle formation during storage generally will only compromise lithographic performance of the resist, or even render the resist composition essentially useless.

### SUMMARY OF THE INVENTION

We have now found new resins that can provide excellent lithographic results when used in a photoresist composition. We also have found that these resins can provide significantly enhanced storage stability, e.g. as exhibited by lack of solution turbidity or particle formation over extended storage times.

The invention thus provides these novel resins (sometimes referred to herein as "resins of the invention") and photoresist compositions that comprise a photoactive component and one or more resins of the invention.

In one aspect, resins of the invention can be characterized by use of a reagent that is a reaction product of a phenol that contains a hydroxymethyl (e.g. HOCH₂-) substituent, such a phenol sometimes referred to herein as a methylol phenol compound. The methylol phenol compound is suitably reacted at above room temperature and/or in the presence of acid, preferably with a suitable solvent such as an alcohol, a lower (e.g. C₁₋₈) aliphatic carboxy acid (e.g. acetic acid) that is in addition to the primary acid for the pretreatment reaction, an ether, or mixtures thereof. The resultant reaction product suitably will be a mixture of oligomers, particularly a mixture of cresol resols. Preferably, a phenol with two or more methylol groups is reacted. Preferably, an aldehyde is not reacted during the pretreatment process.

After such themal/acid pretreatment, the reaction product is then reacted with one or more reactive phenols, preferably in the absence of an aldehyde-containing compound, to provide a resin of the invention. The reactive phenols may suitably include methylol phenolic compounds as well as other reactive compounds such as other phenolic compounds. Aldehydes also may be reacted to form the primary resin, although in some preferred aspects of the invention an aldehyde is not employed. The reaction to form the resin is suitably conducted in the presence of acid.

Preferred photoactive components of resists of the invention include diazonaphthoquinone compounds, including phenolic resins or oligomers that have naphthoquinone ester groups. Photoresists of the invention are particularly useful for imaging with I-line (ca. 365 nm) radiation.

The invention also provides methods for forming relief images, including methods for forming a highly resolved relief image such as a pattern of lines where each line has essentially vertical sidewalls and a line width of about 0.50 microns or less, or even about 0.4 microns or 0.3 microns or less. The invention further provides articles of manufacture comprising substrates such as a printed circuit board substrate, microelectronic wafer or a liquid crystal display or other flat panel display substrate having coated thereon the phororesists and relief images of the invention. The invention also includes methods of synthesis of resins of the invention. Other aspects of the invention are disclosed infra.

### DETAILED DESCRIPTION OF THE INVENTION

As discussed above, the invention includes pretreatment of an alkylhydroxy substituted phenol compound (sometimes referred to herein as a a methylol phenol compound) prior to reaction to form the primary resin of the invention.

It has been found that resins of the invention formulated in photoresist solvents can exhibit significantly enhanced storage stability, e.g. as exhibited by lack of solution turbidity or particle formation (naked eye inspection) of the solution over extended storage times, including six months or more. See, for instance, the results of Examples 8-13 which follow.

The alkylhydroxy phenol compound used in the pretreatment reaction suitably can be any of a number of compounds, including e.g. hydroxybenzyl alcohol, or more preferably a phenol with multiple alkylhydroxy such as 2,6-bis(hydroxymethyl)-p-cresol and other bishydroxymethyl-cresols.

The pretreatment reaction is preferably conducted at a temperature above room temperature, e.g. at about 30°C or greater, more preferably about 50°C or greater, more preferably from about 50°C to 130°C.

The pretreatment reaction also is preferably conducted under acidic conditions, e.g. by addition to the pretreatment reaction mixture of a mineral acid such as HCl, HBr, H₂SO₄, or an appropriate organic acid such as methansulfonic acid, triflic acid and the like. The acid may be suitably employed in relatively small or catalytic amounts, e.g. no more than about 1 to 10 weight percent relative to the methylol phenol that is being pretreated. Higher acid concentrations also may be suitably employed, if desired.

The pretreatment reaction is suitably carried out in a generally non-interfering solvent such as a glycol, glycol ether or other ether, e.g. propylene glycol, 2-propyleneglycol monomethyl ether, propyleneglycol dimethyl ether, [bis(2-methoxyethyl)]ether, and the like; an alcohol or alcohol ether such as n-propanol, n-butyl alcohol, 1 ,3-propanediol, 1,2-propanediol, and the like; a carboxylic acid solvent such as a lower (e.g. 1 to about 8 to 10 carbons) alkyl carboxy acids such as acetic acid, propionic acid and the like; water, typically used in combination with a water-miscible organic solvent such as an alcohol or acid; and other solvents such as a halogen-substituted solvent e.g. CHCl₃ and the like; a nitrile-substituted solvent such as acetonitrile; a nitro-substituted solvent such as nitrobenzene; and the like. Use of a solvent is generally preferred. An alcohol or ether solvent is often preferred. An alcohol solvent also may participate in the pretreatment reaction and modulate the formation of the oligomeric pretreatment reaction product by forming benzyl ethers from hydroxymethyl moieties of the pretreatment reaction product. By stating that the solvent is substantially non-interfering, it is meant that the solvent does not inhibit the reaction in an undesired manner. For example, the solvent can be essentially inert in the reaction, or can modulate the formation of the reaction such as by forming ether groups as discussed above with respect to an alcohol solvent.

In preferred aspects, the pretreatment step is suitably carried out in the absence of any other reagents than phenol(s) with multiple alkylhydroxy substitution, acid if employed, and a substantially non-interfering solvent. See Examples 5-7 which follow for exemplary pretreatment conditions.

Reaction times for the pretreatment step of the invention can vary relatively widely, and will depend on part if both thermal and acidic conditions are employed. Suitable reaction times can be readily determined empirically, e.g. by evaluating if the pretreatment reaction product provides a good quality resin upon further reaction, or meets spectroscopic or other properties of a standard, such as those pretreatment reaction products of the examples which follow. The examples which follow also provide some preferred reaction times, such as 20 minutes at reflux of the reaction mixture (propyleneglyocol monomethyl solvent), followed by ice bath cooling

The pretreatment reaction product need not be isolated from reaction solvent or acid reagent prior to addition of other phenolic compounds to form the primary resin. That is, after formation of the pretreatment reaction product, and preferably cooling of that reaction product to room temperature or below (e.g. ice-bath temperature), additional phenolic compounds can be added to the pretreatment reaction mixture, optionally with additional substantially non-interfering solvent and/or acid reagent.

The pretreatment reaction product often will be a mixture of one or more of a an ether of the methylol phenolic compound (e.g. a benzyl ether of dimethyol phenol), and/or a dimer, trimer, tetramer or higher or oligomer of the methylol phenolic compound. Often, the highest molecular weight species will have an Mw of about 1,000 or less, more typically about 500 or less. The relative concentration of the various pretreatment products can depend on the pretreatment reaction temperature, acid concentration, overall reaction mixture concentration and reaction time. The pretreatment reaction product may be a mixture of at least five different species, or even at least ten different species, or even up to twenty or more different species. The oligomeric species typically will be linked via benzylether and/or methylene linkages, with methylene linkages often being predominate.

As discussed above, the pretreatment reaction product can be reacted with a variety of other phenolic compounds and other monomers to provide a resin of the invention. For example, the pretreatment reaction product can be further reacted with a variety of phenolic compounds, including methylol phenolic compound such as monooxymethyl phenolic compounds and bisoxymethyl phenolic compounds, which are in many cases preferred. Some specifically preferred phenolic compounds to react with the pretretment reaction product include Some preferred compounds to react with the pretreatment reaction product include other phenolic compounds such as o-cresol, m-cresol, p-cresol, 2,3-dimethylphenol, 3,5-dimethylphenol, 2,5-dimethylphenol, 2,3 - dimethylphenol, 3,4-dimethylphenol, 2,3,5-trimethylphenol, and the like.

Monooxymethyl phenolic compounds and bisoxymethyl phenolic compounds that are particularly useful for reaction with the pretreatment reaction product include those represented by the following formulae: 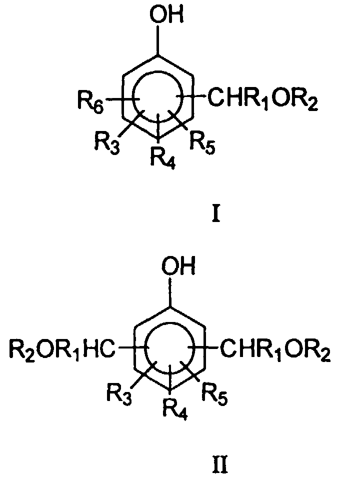 where for each formula:
R₁ is hydrogen, an alkyl (which includes cycloalkyl such as cyclohexyl and the like) having 1 to about 12 carbon atoms, an aryl such as phenyl, or a heterocyclic group, but preferably is H;
R₂ is hydrogen, an alkyl or an acyl group having 1 to about 12 carbon atoms, but preferably is hydrogen or methyl;
R₃, R₅ and R₆ are each hydrogen, halogen, an alkyl group including cycloalkyl (such as cyclohexyl) having from 1 to about 12 carbon atoms, an alkoxy group having 1 to about 4 carbon atoms, a phenoxy group, an aryl group or an arylalkyl group such as phenyl, benzyl and the like; and
R₄ is the same as R₃ and R₅, and in addition is a carboxylic group.

The bisoxymethyl phenolic compound is highly reactive and often is in the form of its dimer having the following formula: 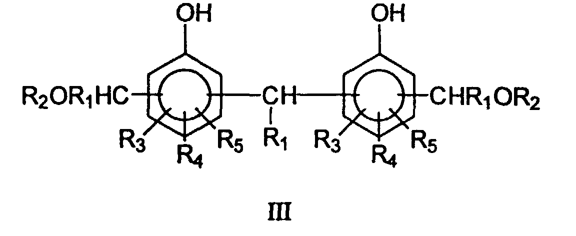 where each of R₁ through R₅ is as defined above.

Bisoxymethyl phenolic compounds may be formed by the reaction of formaldehyde with o-cresol, m-cresol, p-cresol, phenol, 2-phenyl phenol, 3-phenyl phenol, 4-phenyl phenol, 2,3-dimethyl phenol, 2,5-dimethyl phenol, 3,4-dimethyl phenol, 3,5-dimethyl phenol, 3,4,5-trimethyl phenol, 2-ethyl phenol, 4-ethyl phenol, 2-isopropyl-5-methyl phenol, p-propyl phenol, p-butyl phenol, p-nonyl phenol, bromophenols, fluorophenols, chlorophenols, trimethylsilylphenol, chloromethylphenols, acylphenols, p-hydroxybenzoic acid, p-nitro phenol, 2-cyclopentyl phenol, 4-cyclopentyl phenol, 2-cyclohexyl phenol, 4-cyclohexyl phenol, 5-cyclohexyl-2-methyl phenol, 2-cyclohexyl-5-methyl phenol, and the like, in the presence of a base. Suitable bases which will promote the reaction include alkaline earth metal hydroxides such as lithium and sodium hydroxide, and metal-free bases such as tetramethyl ammonium hydroxide. The concentration of the formaldehyde in the reaction mixture together with solvents and reaction conditions will determine whether the bisoxymethyl phenolic compound or its dimer will be formed.

Monooxymethyl phenolic compounds are made in a manner similar to the bisoxymethyl phenolic compounds except that one or more of the phenolic reactive sites is desirably blocked with a blocking group to prevent formation of the bisoxymethyl phenolic compound. Any non-reactive group is satisfactory. The preferred blocking group is an alkyl group substituted onto the phenolic ring having from 1 to 8 carbon atoms, methyl being most preferred. Exemplary phenols suitable for formation of the monoxymethyl phenolic compound include 2,6-dimethyl phenol, 2-methyl-4-isopropyl phenol, 2,4-dimethyl phenol, 2,3,6-trimethyl phenol, 2,3,5,6-tetramethyl phenol, 2,3,4-trimethyl phenol, 2-cyclohexyl-4-methyl phenol, 2-cyclopentyl-4-methyl phenol, 4-cyclohexyl-2-methyl phenol, etc. The reaction conditions used to form the monoxymethyl phenolic compound and procedures would be substantially the same as used to form the bisoxymethyl phenolic compounds.

The oxymethyl groups of the above preformed phenols are reactive and in the presence of heat and acid or base, may react with other oxymethyl groups present in the reaction mixture, or with another reactive compound. If the reactive compound is another phenolic material, such as phenol, a cresol, a dimethylphenol, a trimethylphenol, a naphthol, a biphenol, a phenylphenol, a bis(hydroxyphenyl)methane, an isopropylidenebisphenol, a catechol, a resorcinol, a thiobiphenol or the like which contains at least two sites in the aromatic ring(s) of sufficient reactivity to undergo a facile Friedel-Crafts reaction, then the condensation reaction of the reactive compound with the preformed bisoxymethyl phenolic compound will sustain polymerization and result in the formation of the desired alternating copolymers. The key to formation of alternating copolymers rather than a random copolymer, is the absence of an aldehyde during reaction.

The above discussed bisoxymethyl phenolic and monoxymethyl phenolic compounds and other compounds also may used as reagents in the pretreatment reaction to form the pretreatment reaction product.

To prepare polymers in accordance with the invention, the reactants, i.e. pretreatment reaction products, and other reagents such as a bisoxymethyl phenolic compound and/or monooxymethyl phenolic compound if employed, are dissolved in an appropriate non-reactive or non-interfering solvent and an acid catalyst is added. As mentioned above, some preferred compounds to react with the pretreatment reaction product include other phenolic compounds such as o-cresol, m-cresol, p-cresol, 2,3-dimethylphenol, 3 ,4-dimethylphenol, 3 ,5-dimethylphenol, 2,5-dimethylphenol, 2,3-dimethylphenol, 2,3,5-trimethylphenol, and the like. An aldehyde is desirably not present during the formation of the resin. When a volatile reactive phenolic compound is used in excess, it may also serve as a solvent or co-solvent for the reaction mixture.

The condensation reaction leading to polymer formation may be carried out below, at, or above ambient temperature. It is generally more practical to conduct the reaction at elevated temperature. A suitable acid catalyst is typically and may be the same acid as used in the pretreatment reaction, although acids other than that used in the pretreatment step also may be employed, including a stronger acid. Suitable acids include mineral acids such as hydrochloric acid, sulfuric acid, phosphoric acid, or an organic acid such as oxalic acid, maleic acid, formic acid, toluene sulfonic acid and the like. In certain cases, an inorganic catalyst may also be used. Suitable inorganic catalysts include compounds of zinc, manganese, magnesium, aluminum, titanium, copper, nickel and cobalt. Upon completion of the condensation reaction, the solvent and unreacted reactive phenolic compound may be removed by volatilization under reduced pressure and elevated temperature. The preferred method by which the polymer may be recovered from the reaction mixture is by precipitation of the polymer into a liquid which is a non-solvent for the polymer but a solvent for the reaction solvent, catalyst and unreacted reactants. If this precipitation approach is used, the polymer is recovered and dried under reduced pressure. The resulting polymer is a substantially alternating copolymer having a weight average molecular weight to number average molecular weight not exceeding 4 and preferably not exceeding 3. Alternatively, the precipitated polymer may be dissolved in a water immiscible solvent, washed one or more times with water, an organic solvent added (particularly a photoresist solvent) and the water immiscible solvent removed by distillation.

Resins of the invention are useful as coating compositions, particularly for the formulation of photoresist coating compositions. As discussed above, photoresists are well-known in the art and described in numerous publications.

Positive-acting resists of the invention contain a resin of the invention and a light sensitive component. The light sensitive components sensitizers are suitably esters and amides formed from o-quinone diazide sulfonic and carboxylic acids. These esters and amides are well-known in the art and are described by DeForest, supra, pp. 47-55, incorporated herein by reference. These light sensitive compounds, and the methods used to make the same, are all well documented and prior patents including German Patent No. 865,140 granted February 2, 1953 and U.S. Patent Nos. 2,767,092; 3,046,110; 3,046,112; 3,046,119; 3,046,121; 3,046,122 and 3,106,465 all incorporated herein by reference. Additional sulfonic amide sensitizers that have been used in the formulation of positive-acting photoresists are shown in U.S. Patent No. 3,637,384, also incorporated herein by reference. These materials are formed by the reaction of a suitable diazide of an aromatic sulfonyl chloride with an appropriate resin amine. Methods for the manufacture of these sensitizers and examples of the same are shown in U.S. Patent No. 2,797,213, incorporated herein by reference. Other positive-working diazo compounds have been used for specific purposes. For example, a diazo compound used as a positive-working photoresist for deep U.V. lithography is Meldrum's diazo and its analogs as described by Clecak et al., Technical Disclosure Bulletin, Volume 24, No. 4, September 1981, IBM Corporation, pp. 1907 and 1908 and o-quinone diazide compounds suitable for laser imaging as shown in U.S. Patent No. 4,207,107.

Negative-acting resists are also provided. Such resists suitably contain a resin of the invention and a negative-acting sensitizer such as an aromatic azide as described by Iwayanagi et al., IEEE transactions on electron devices, volume ED-28, No. 11, November, 1981; U.S. Patents 3,869,292, 2,940,853 and 2,852,379; and DeForest, supra.

Photoresists of the invention can be employed in a wide range of applications. For example, resists of the invention can be employed as a mask to protect substrates from chemical etching and photo-engraving processes. For instance, in a conventional process for the manufacture of a printed circuit board, a copper-clad substrate can be coated with a photoresist of the invention, preferably a positive-acting resist, that coating exposed to actinic radiation to form a latent circuit image in the photoresist coating, the coating developed with a liquid developer to form a relief image and etched with a chemical etchant whereby unwanted copper is removed and copper protected by the photoresist mask is left behind in a circuit pattern.

Photoresists of the invention also may be employed to manufacture semiconductors and liquid crystal displays and other flat panel displays. As in the manufacture of printed circuits, the photoresist is coated onto the surface of a semiconductor wafer or flat panel display substrate and then imaged and developed. Following development, the microelectronic wafer or other susbtrate is typically etched with an etchant whereby the portions of the wafer bared by the development of the photoresist are dissolved while the portions of the wafer coated with photoresist are protected, thereby defining a circuit pattern.

To formulate a photoresist using a resin of the invention, a radiation sensitive compound is admixed with a resin of the invention. The radiation sensitive compound used may be any of the various radiation sensitive compounds known to be suitable as photoactive compounds in photoresist compositions formulated with an alkali soluble polymer, including those specifically discussed herein. Preferred compounds in accordance with the subject invention include esters formed from o-quinone diazide sulfonic and carboxylic acids. Alternatively, aromatic azide compounds may be used. More preferred sensitizers include esterified diazo naphthoquinone compounds. Especially preferred sensitizers include the 2,1,4-diazonaphthoquinone sulfonic esters and the 2,1,5-diazonaphthoquinone sulfonic acid esters. Other naphthoquinone diazide sulfonic acid esters suitable as sensitizers in the compositions of the invention are disclosed in Kosar, *Light Sensitive Systems*, John Wiley & Sons, 1965, pp. 343 to 352, incorporated herein by reference.

The amount of the sensitizer used in the photoresist composition and the manner of preparing the same is in accordance with art recognized procedures. In this respect, dependent upon the specific sensitizer and resin binder blend, the sensitizer can vary from 0.1 to 55 weight percent of the composition. In general, lower molecular weight sensitizers are used in lower amount while higher molecular weight sensitizers having backbones similar in structure to the resin binder can be used in higher concentrations.

A photoresist of the invention is prepared by dissolving the components in a suitable photoresist solvent. Known photoresist solvents include, for example, ether esters such as ethyl cellosolve acetate, methyl cellosolve acetate, and propylene glycol monomethyl ether acetate; ether alcohols such as ethyl cellosolve, methyl cellosolve, anisole, propylene glycol monomethyl ether; carboxylates such as ethyl acetate, butyl acetate and amyl acetate; lactones such as butyrolactone; cyclic ketones such as cyclohexanone and 2-heptanone; carboxylates of di-basic acids such as diethyloxylate and diethylmalonate; dicarboxylates of glycols such as ethylene glycol diacetate and propylene glycol diacetate; and hydroxy carboxylates such as ethyl-2-hydroxy propionate (ethyl lactate), and ethyl-3-hydroxy propionate. Solvents may be used alone or in admixture with each other and may be further mixed with non-solvents for one or more of the constituents. Suitable photoresist coating compositions can contain up to 50% by weight solids and preferably from 20 to 40% solids.

Other components may be added to a photoresist coating composition. For example, other phenolic resins such as aromatic novolak resins unreacted with the o-quinone diazide component, conventional novolak resins and polyvinylphenols may be mixed into the photoresist coating composition. The additional phenolic resins may be used in amounts of from 0 to 25 times the amount of the total of the photoactive components, preferably in amounts of 1 to 15 times the amount of the photoactive components and more preferably, in amounts of from 1 to 10 times the amount of the photoactive components. To augment performance, other conventional o-naphthoquinonediazide photoactive compounds may be added to the composition. Such materials are known in the art and disclosed in numerous patents including U.S. Patent Nos. 3,046,118; 3,046,120; and 5,178,986, all incorporated herein by reference. The concentration of the additional photoactive compound can vary from between 1 and 30% by weight of the total of the resin components in the photoresist composition, inclusive of the aromatic novolak resin condensed with the o-quinonediazide sulfonyl group, and preferably between 2.5 and 20%. Other additives that may be added to the photoresist coating composition include actinic and contrast dyes, anti-striation agents, plasticizers and the like.

In one preferred embodiment, a resin of the invention is used as one component of a blend of resins. For example, a suitable resin for blending with a resin of the invention comprises the aromatic novolaks disclosed in U.S. Patent No. 5,216,111 incorporated herein by reference. The aromatic novolak resins are acid catalyzed condensation products of one or more phenols and an aromatic aldehyde formed by the condensation of the reactants in the presence of a strong organic or mineral acid optionally in the presence of a divalent sulfur compound as a co-catalyst. The phenol is of the type conventionally used in the formation of novolak resins such as, for example, phenol itself, the cresols, xylenols, resorcinols, naphthols, bisphenols such as 4,4'-isopropylidenebisphenol and mixtures of such phenols. Preferred phenols include the cresols, m-cresol being most preferred because it yields a polymer with a widest dissolution range.

In addition to the aromatic novolak resins, other conventional novolak resins and other phenolic resins suitable for use in a photoresist composition may be admixed with a resin of the invention. The additional phenolic resin may be used in amounts of from 0 to 7 times the amount of the resin of the invention.

In a further preferred embodiment,a resin of the invention, which may be in combination with another resin such as the above described aromatic novolak resin, is used with mixed photoactive compounds where one component of the mixture is an aromatic novolak resin condensed with an o-quinone diazide sulfonyl compound. Photoactive compounds comprising an aromatic novolak resin condensed with an o-quinone diazide sulfonyl compound are disclosed in U.S. Patent No. 5,589,553 incorporated herein by reference. They are preferably condensation products of those resins having a molecular weight of at least 1,200 daltons and more preferably, a molecular weight ranging between 1,700 and 3,000 daltons, a glass transition temperature of at least 85°C and preferably from about 130°C to 220°C, a polydispersity (ratio of weight average molecular weight to number average molecular weight) of from 1.6 to 4.0; and a dissolution rate in a standard developer (polymer prior to esterification) of at least 200 angstroms per second and more preferably, from about 1,200 to 3,500 angstroms per second.

The aromatic novolak resin is esterified with an o-quinonediazide sulfonyl compound to form a photoactive component. Examples of suitable o-naphthoquinonediazide groups include a 1,2-naphthoquinonediazide-4-sulfonyl group, a 1,2-naphthoquinonediazide- 5-sulfonyl group, a 2,1-naphthoquinonediazide-4-sulfonyl group, a 2,1-naphthoquinonediazide- 6-sulfonyl group, a 2,1-naphthoquinonediazide-7-sulfonyl group, and a 2,1-naphthoquinonediazide-8-sulfonyl group. These groups may be used alone or in combination as a mixture. Among these groups, a 1,2-naphthoquinonediazide-4-sulfonyl group and a 1,2-naphthoquinonediazide- 5-sulfonyl group are particularly preferred.

The condensation reaction with the o-quinonediazide sulfonyl halide is carried our in a water miscible, non-interfering or inert solvent. Normally, the material to be esterified and the sulfonyl chloride are dissolved in acetone or dioxane forming an 8 to 25 w/w% solution. The solution temperature is adjusted and a solution of an organic base such as triethylamine (10 to 50 w/w%) which is slowly added to drive the reaction. This is followed by a reaction period of about 0.5 to 4 hours at a constant temperature. Normal reaction temperatures may vary from about 20° to 40°C. If the salt byproduct forms a precipitate, it is filtered and the filtrate neutralized with a mineral acid such as hydrochloric acid. If appropriate, the solution is filtered and then it is added to a non-solvent such as water to separate the esters from the solvent. After collection and washing, the product is dried under reduced pressure at about 30° to 55°C. When a 1,2-naphthoquinonediazide-4-sulfonate is used, the product is imaged at a wavelength of within the range of from 330 to 420 nm. When a 1,2-naphthoquinonediazide-5-sulfonate is used, the photoresist is desirably imaged at a wavelength within the range of 330 to 450 nm. Photoactive compounds of this nature may be used in higher concentration than comparable lower molecular weight photoactive compounds and may be present in a concentration of from about 20 to 45 weight percent of solids.

When a resin of the invention is used in combination with a photoactive compound that is the condensation product of an aromatic novolak resin, the photoactive compound may be used in larger concentration because of the compatibility of the backbone of the photoactive compound and the resin binder. In this instance, the photoactive compound may be present in amounts as high as 35 to 60 weight percent of total solids.

A resin of the invention, with or without the addition of another phenolic resin, and with or without the naphthoquinone diazide sulfonyl esterification product of the aromatic resin, may also be used with other photoactive compounds. In this respect, another preferred photoactive compound suitable for use with the alternating copolymer of the invention is disclosed in U.S. Patent No. 5,529,880 incorporated herein and comprises the esterification product of an o-quinone diazide sulfonyl compound and a high molecular weight phenol having from 2 to 5 phenolic rings and at least 4 hydroxyl groups where an average of at least 50% of the phenolic hydroxyl groups are esterified with the o-quinone diazide sulfonyl groups.

Preferred polyhydric phenols have at least two phenyl rings and at least two hydroxyl groups. Most preferred polyhydric monomeric phenols conform to the general formula: 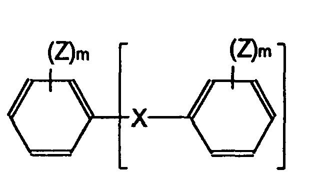 where each Z independently may be the same or different and each is a member selected form the group consisting essentially of a hydrogen atom, an alkyl group, an aryl group, a halogen atom or a hydroxyl group, provided that at least four of said Z's are hydroxyl and preferably, there is at least one hydroxyl group on each ring; each m is a whole integer varying between 1 and 5; X is a single bond or a member from the group consisting essentially of CO, S, O, SO₂, and CR₁ and R₂ where R₁ and R₂ each is independently a member selected from the group consisting of hydrogen, halogen, hydroxy, alkyl having 1 to 6 carbon atoms, alkoxy having 1 to 6 carbon atoms, and aryl and n is a whole integer varying between 1 and 4. Compounds corresponding to the above formula are known in the art and disclosed in multiple publications including U.K. Patent No. 935,250; EPO published application No. 0 341 608 A2, U.S. Patent Nos. 3,188,210; 4,266,000; 4,424,270; 4,555,469 and 5,290,656; each incorporated herein by reference. Suitable phenols represented by the above formula include 2,2',3,4-tetrahydroxybenzophenone, 2,4,2',4' -tetrahydroxydiphenyl sulfide, 2,2',4,4'-tetrahydroxydinaphthylmethane, 2,3,4,4'-tetrahydroxy-2,2'-methyl-5,5'-di-tert-butyldiphenyl sulfide, 4,4' -dihydroxydiphenyl sulfide, 4,6-bis-(2 ,4-dihydroxyphenylthio)-resorcinol, 2,4,2',4' -tetrahydroxy-3,5,3',5'-tetrabromodiphenyl sulfone, 2,4,2',4'-tetrahydroxy-3,5,3',5'-tetrabromobiphenyl and 2,2',4,4'-tetrahydroxy-3,5-dibromobenzophenone.

Other preferred polyhydric phenols include 4,4'-[(4-hydroxyphenyl)methylene]bis[2-methylphenol], 4,4'-[(2-hydroxyphenyl)methylene]bis[3-methylphenol], 2,6-bis(2,4-dihydroxybenzyl)-p-cresol, 2,6-bis(2,4-dihydroxybenzyl)-3,4-dimethylphenol, 2,6-bis(2,4-dihydroxy-3-methylbenzyl)-4-methyl phenol, 2,6-bis(2,4-dihydroxy-5-ethylbenzyl)-4-methylphenol, α,α'-bis(2,4-dihydroxy-5-ethyl)phenyl-2-merhylthiophene, α,α' - bis(2,4-dihydroxy-5-ethyl)phenyl-2-methyl-5-methylfuran, α,α' -bis(4-hydroxy-2,3,6-trimethyl)phenyl-2-methylthiophene, 4,4'-[(2-hydroxyphenol)methylene]bis[2,3,5-trimethylphenol], 4,4'-[2-hydroxyphenyl)methylene]bis[2,3,6-trimethylphenol], α,α' - bis(2,4-dihydroxy-5-ethyl)phenyl-2-methylphenol, α ,α' -bis(2,4-dihydroxy-5-chloro)phenyl-2-methylphenol, α,α '-bis(3 ,4-dihydroxy-6-methyl)phenyl-2-methylphenol.

The photoactive compounds of a polyhydric phenol are formed by esterification using the materials and procedures described above.

All documents mentioned herein are fully incorporated herein by reference. The following non-limiting examples are illustrative of the invention.

### EXAMPLES 1-7 -- Resin synthesis with and without pretreatment of the invention

### Example 1 -- Synthesis of 2,3 -dimethylphenol-2,6-bis(hydroxymethyl)-p-cresol resin (without pretreatment).

To a 2 L 3-necked round button flask equipped with a reflux condenser, paddle stirrer and thermometer were added 1L of 2-propyleneglycol monomethyl ether, 220 g of 2,3-dimethylphenol and 202 g of 2,6-bis(hydroxymethyl)-p-cresol. Heat was then applied. At about 40°C 20 mL HCl was added. At about 60°C the remainder of the HCl (104 mL) was added. The batch was heated to reflux and kept at reflux for 5 hours. The reaction solution was then slowly precipitated into 20 L of de-mineralized water. The precipitate was then collected onto a filter, rinsed with de-mineralized water, and again washed by soaking in 13 L de-mineralized water for at least one hour. After collection on the filter the product was transferred into two large glass trays to air dry. Final drying was achieved using a 50-70°C vacuum oven under vacuum. 368 g of an off-white powder was obtained having a weight average molecular weight of 1700 and a number average molecular weight of 930 Daltons.

### Example 2-- Synthesis of 2,3-dimethylphenol, 2,5-dimethylphenol, 2,6-bis(hydroxymethyl)-p-cresol resin. (without pretreatment).

To a 1 L 3-necked round bottom flask equipped with a stirrer, heater, thermometer and reflux condenser were added 620 mL of 2-propyleneglycol monomethyl ether, 73.3 g of 2,3-dimethylphenol, 36.7 g of 2,5-dimethylphenol and 103.4 g of 2,6-bis(hydroxymethyl)-p-cresol. While the mixture was heated to reflux 60 mL of concentrated hydrochloric acid was added in parts between 40 and 60°C. The reaction solution was heated at reflux for about 2 hours and then precipitated into 10 L of de-mineralized water. The product was collected by filtration, soaked in de-mineralized water, again collected and vacuum dried at 75°C. This produced about 187 g of resin having a weight average molecular weight of about 1700 and a dissolution rate of about 440Å/sec. in aqueous 0.24N tetramethylammonium developer (Shipley Company MF701 Developer).

### Example 3 -- Synthesis of 2,3-dimethylphenol, 2,6-bis(hydroxymethyl)-p-cresol, 4-hydroxy-3,5-dimethylbenzyl alcohol resin (without pretreatment).

To a 0.5 L 3-necked round bottom flask equipped with a stirrer, heater, thermometer and reflux condenser were added 300 mL of 2-propyleneglycol monomethyl ether, 73.3 g of 2,3-dimethylphenol, 50.5 g of 2,6-bis(hydroxymethyl)-p-cresol and 13.3 g of 4-hydroxy-3,5-dimethylbenzyl alcohol. While the mixture was heated to reflux 48 mL of concentrated hydrochloric acid was added in parts between 40 and 60°C. The reaction solution was heated at reflux for about 2 hours and then precipitated into 5 L of de-mineralized water. The product was collected by filtration, soaked in de-mineralized water, again collected and vacuum dried at 75°C. This produced about 115.5 g of resin having a weight average molecular weight of about 1050 and a dissolution rate of about 4080Å/sec. in aqueous 0.24N tetramethylammonium hydroxide developer (Shipley Company MF701 Developer).

### Example 4―(thermal pretreatment (without acid))

To a 1 L 3-necked round bottom flask equipped with a stirrer, heater, thermometer and reflux condenser were added 600 mL of 2-propyleneglycol monomethyl ether, 104.7 g of 2,6-bis(hydroxymethyl)-p-cresol, 74.2 g of 2,3-dimethylphenol and 33.0 g of 2,5-dimethylphenol. The mixture was heated and kept at reflux for about 30 minutes, and then cooled with an ice-water bath to 53°C. To the mixture was then added 60 mL of concentrated HCl. The mixture was heated and kept at reflux for about 2.5 hours before precipitated into 10 L of de-mineralized water. The product was collected by filtration, soaked in de-mineralized water, again collected and vacuum dried at 75°C. This produced about 189.3 g of resin having a weight average molecular weight of about 1917 and a dissolution rate of about 245Å/sec. in aqueous 0.24N tetramethylammonium hydroxide developer (Shipley Company MF701 Developer).

### Example 5 ― (with pretreatment)

To a 1 L 3-necked round bottom flask equipped with a stirrer, heater, thermometer and reflux condenser were added 300 mL of 2-propyleneglycol monomethyl ether, 104.7 g of 2,6-bis(hydroxymethyl)-p-cresol and 10 mL of concentrated hydrochloric acid. The mixture was heated and kept at reflux for 20 minutes, then cooled with an ice-water bath to ambient temperature. To the reactor was then added a solution comprising of 300 mL of 2-propyleneglycol monomethyl ether, 74.2 g of 2,3-dimethylphenol, 33.0 g of 2,5-dimethylphenol and 50 mL of concentrated hydrochloric acid. The reaction mixture was heated at reflux for about 2.5 hours and then precipitated into 10 L of de-mineralized water. The product was collected by filtration, soaked in de-mineralized water, again collected and vacuum dried at 65°C. This produced about 190.6 g of resin having a weight average molecular weight of about 1955 and a dissolution rate of about 32Å/sec. in aqueous 0.24N tetramethylammonium hydroxide developer (Shipley Company MF701 Developer).

### Example 6― (with pretreatment)

The resin was synthesized in the same manner as in Example 5 above except that the acid was present in higher concentration during the pre-treatment step. Thus 104.7 g of 2,6-bis(hydroxymethyl)-p-cresol and 30 mL of concentrated hydrochloric acid were heated and kept at reflux for 20 minutes. After the reaction solution had cooled a solution comprising of 300 mL of 2-propyleneglycolmonomethyl ether, 74.2 g of 2,3-dimethylphenol, 33.0 g of 2,5-dimethylphenol and 30 mL of concentrated hydrochloric acid was added and again the mixture heated to reflux. After the work-up and drying about 187 g resin was obtained having a weight average molecular weight of 1954, a differential scanning coulometry glass transition temperature of 95°C and a dissolution rate of 14Å /sec in aqueous 0.24N tetramethylammonium hydroxide developer (Shipley Company MF 701 developer).

### Example 7 ― (with pretreatment)

To a 1 L 3-necked round bottom flask equipped with a stirrer, heater, thermometer and reflux condenser were added 250 mL of 2-propyleneglycol monomethyl ether, 60.55 g of 2,6-bis(hydroxymethyl)-p-cresol and 25 mL of concentrated hydrochloric acid. The mixture was heated to reflux, kept at reflux for 20 minutes and then cooled with an ice water bath to ambient temperature. To the reactor was then added a solution comprising of 240 mL of 2-propyleneglycol monomethyl ether, 87.96 g 2,3-dimethylphenol, 16.42 g of 4-hydroxymethyl-2,6-dimethylphenol and 25 mL concentrated hydrochloric acid. The reaction mixture was heated at reflux for two hours followed by precipitation into 9 L de-mineralized water. After the product was collected on a filter, washed and soaked in 6 L de-mineralized water it was dried under vacuum at 50°C to give about 144.1 g of resin. The obtained resin was found to have a weight average molecular weight of 1116, a dissolution rate of 2056Å/sec. in aqueous 0.24N tetramethylammonium hydroixde developer (Shipley Company MF 701 Developer) and a glass transition temperature of 43°C.

### EXAMPLES 8-13 ― Solution Stability Tests

Solution Stability Test Showing that the 2,6-bis(hydroxymethyl)-p-cresol (DMPC) pre-treatment step results in a resin with improved solution stability. This is most pronounced in solvents such as the lower alcohols and ethyl lactate, anisole and amyl acetate.The following Examples summarize resin solution stability of improved resins over the references. These test were conducted by dissolving 40% by weight of resin in ethyl lactate and monitoring the solution for turbidity or precipitation as it stood at ambient temperature.

| Tested Resin | First Onset of Turbidity/Precipitation |
|---|---|
| Example 8 -- Resin of Example 1 | <3 Days |
| Example 9 -- Resin of Example 2 | <50 Days |
| Example 10 -- Resin of Example 3 | <50 Days |
| Example 11 -- Resin of Example 4 | <30Days |
| Example 12 -- Resin of Example 5 | >240 Days |
| Example 13 -- Resin of Example 6 | >240 Days |

### EXAMPLES 14-15 ― Preparation of aromatic novolak resins, including such resins esterified with PAC.

### Example 14 -- m-Cresol Salicylaldehyde-Benzaldehyde Resin

A mixture of 194.8 g of m-cresol, 113.4 g of benzaldehyde, 89.5 g of salicylaldehyde, 1.0 L of ethanol and 0.1 L concentrated hydrochloric acid were charged into a 2 L 3-necked round bottom flask equipped with a mechanical stirrer, heating mantle, reflux condenser and a nitrogen inlet tube. The mixture was heated to and kept at reflux for about 24 hours. The reaction mixture was transferred to an addition funnel and slowly added into 6 L of de-mineralized water and after a 1-hour soak, was again collected on the Buchner filter and rinsed. The resin was partially air dried to remove the bulk of the water and further dried under vacuum at 65°C to 68°C. The yield was about 360.4 g of powder having a glass transition temperature of about 158°C and a weight average molecular weight of about 1823 Daltons.

### Example 15 -- o-Naphthoquinonediazide Esterified Aromatic Resins

A 1 L 3-necked round bottom flask equipped with a water bath, stirrer and thermometer was charged with 700 mL of acetone, 100 g of the resin prepared according to the above Example 14 and having a dissolution rate of about 560Å /sec., and 16.32 g of 1,2-naphthoquinone-(2)-diazide-5-sulfonyl chloride. The mixture was warmed to about 30°C and a base solution comprising about 7.74 g of triethylamine in 25 mL acetone was slowly added in about 15 minutes. The reaction mixture was then maintained at about 30°C for 2 hours to complete the esterification reaction. After this period, the excess base was neutralized with hydrochloric acid and the solution slowly added to about 7 L of de-mineralized water to precipitate the product. The product was collected using a Buchner funnel assisted by partial vacuum, rinsed with water and reslurried in 3 L of water. Again, the product was collected with the funnel, rinsed with water and partially air dried on the filter. Final drying was achieved at about 40°C to 50°C under vacuum. About 110 g of esterified aromatic resin containing about 8.5 percent 1,2-naphthoquinone-(2)-diazide-5-sulfonic acid ester groups was obtained.

### EXAMPLE 16 ― Photoresist preparation and lithographic processing

Two photoresist compositions were prepared as follows and referred to below as Resist One and Resist Two respectively. Each of Resists One and Two contained a photoactive mixture of 1,2-naphthoquinone diazide-5-sulfonyl mixed esters of 4,4 -[(2-hydroxyphenyl)methylene]bis[2,3,5-trimethylphenol] (referred to below simply as the "PAC") and the 1,2-naphthoquinone diazide-5-sulfonyl esters of Example 14 (referred to below as "PAC of Example 14"). That PAC mixture together with specified resins were dissolved in a solvent mixture of ethyl lactate, methyl phenol ether and amyl acetate (70:20:10) (that mixture referred to as "Solvent" below). Total solid concentration of each of Resists One and Two was adjusted to 22%. The composition of each of Resists One and Two are given below:

| Resist 1 | |
|---|---|
| Component | Amount |
| Resin of Example 5 | 4.95 g |
| Resin of Example 2 | 1.24 g |
| PAC | 0.83 g |
| PAC Ester of Example 14 | 6.18 g |
| Solvent | 46.5 g |

| Resist 2 | |
|---|---|
| Component | Amount |
| Resin of Example 5 | 3.09 g |
| Resin of Example 7 | 2.06 g |
| PAC Ester of Example 14 | 5.15 g |
| PAC | 0.69 g |
| Solvent | 38.74 g |

Each of Resists One and Two were made into homogeneous solutions, and the solutions were passed through a microfilter having a pore size of 0.2 m. Each photoresist was spin coated onto over same bottom anti-reflective organic coating (1510 Å coating) that overcoated silicon wafers. The respective resist layers were dried at 90°C for 60 seconds with a vacuum contact hot plate, thereby forming resist films having a thickness of 0.75 µm. Each resist film was then exposed to activating radiation light by means of a reducing projection exposure apparatus (ASML 5500/200) with a numerical aperture of 0.6 and partial coherence of 0.75, subjected to a post exposure bake at 110°C for 60 seconds, developed for 60 seconds with 0.26N tetramethylammonium hydroxide aqueous solution, washed with D.I. water for 15 seconds and then spin dried. Lithographic results for each of Resists One and Two are set forth in the below Table. These results are for dense lines and spaces.

**Table**

| | Profile | Size | Resolution | DOF |
|---|---|---|---|---|
| Resist One: | clean | 0.25µm | 0.225µm | 1.4µm |
| Resist Two: | clean | 0.25µm | 0.23µm | 1.1µm |

The foregoing description of the invention is merely illustrative thereof, and it is understood that variations and modification can be made without departing from the spirit or scope of the invention as set forth in the following claims.

## Claims

1. A photoresist composition comprising a photoactive component and a resin that is obtainable steps comprising reacting a methylol phenolic compound in the presence of acid to provide a prepolymer, and reacting the prepolymer with one or more phenolic compounds.

2. The photoresist of claim 1 wherein the methylol phenolic compound is reacted in the absence of an aldehyde.

3. The photoresist of claim 1 wherein the methylol phenolic compound is reacted in the presence of acid and in the presence of a further solvent.

4. The photoresist of claim 1 wherein the further solvent is an ether, an alcohol, an alcohol ether, an alkyl carboxy acid, a nitrile-substituted solvent, a nitro-substitued solvent, a halogen-substituted solvent, or water, or a mixture thereof.

5. The photoresist of claim 1 wherein the methylol phenolic compound is reacted above room temperature.

6. The photoresist of claim 1 wherein the methylol phenolic compound is reacted at from about 35°C to about 130°C.

7. The photoresist of claim 1 wherein the methylol phenolic compound is reacted at an elevated temperature for at least about 10 minutes.

8. The photoresist of claim 1 wherein the methylol phenolic compound is a bis(hydroxymethyl)-phenol.

9. The photoresist of claim 1 wherein prepolymer comprises a mixture of two or more of an ether of the methylol phenolic compound, or a dimer, trimer or tetramer of the methylol phenolic compound.

10. The photoresist of claim 1 wherein the prepolymer comprises a mixture of compounds that each have a molecular weight of less than about 1,000.

11. The photoresist of claim 1 wherein the composition is positive-acting and comprises a naphthoquinone diazide photoactive component.

12. The photoresist of claim 1 wherein the composition does not exhibit turbidity of particle formation for at least more than six months after preparation.

13. A method for preparing an article of manufacture comprising:
a) preparing a photoresist composition comprising reacting a methylol phenolic compound in the presence of acid to provide a prepolymer, and reacting the prepolymer with one or more additional phenolic compounds to provide a phenolic resin, and admixing the phenolic resin with a photoactive compound;
b) applying a coating layer of the photoresist composition to a substrate; and
c) exposing the photoresist coating layer to patterned activating radiation, and developing the exposed photoresist coating layer to provide a photoresist relief image.

14. The method of claim 13 wherein the substrate areas bared upon development are etched or plated.

15. The method of claim 13 wherein the substrate is a microelectronic wafer.

16. The method of claim 13 wherein the photoresist coating layer is exposed with radiation having a wavelength of about 365 nm or about 436 nm.

17. The method of claim 13 wherein the methylol phenolic compound is reacted in the absence of an aldehyde.

18. The method of claim 13 wherein the methylol phenolic compound is reacted with the acid in the presence of an alcohol, ether, carboxylic acid or water.

19. A method for preparing a phenolic polymer, comprising:
reacting a hydroxyalkyl phenolic compound in the presence of acid to provide a prepolymer, and reacting the prepolymer with one or more additional phenolic compounds to provide a phenolic resin.

20. The method of claim 19 wherein the hydroxylalkyl is a methylol phenolic compound and reacted with the acid in the presence of a solvent.

21. A resin that is obtainable by steps comprising reacting a hydroxyalkyl phenolic compound in the presence of acid to provide a prepolymer, and reacting the prepolymer with a one or more other phenolic compounds.
